# EUROPEAN PATENT APPLICATION

(11) **EP 4 593 056 A2**
(43) Date of publication of application: **30.07.2025**
(21) Application number: 25182767.1
(22) Date of filing: 13.06.2025
(51) Int. Cl.: H01J 37/22

(54) **OPTICAL BEAM MEMBER**

(71) Applicant: ASML Netherlands B.V., 5500 AH Veldhoven (NL)
(72) Inventor: KUIPER, Vincent, Sylvester, 5500 AH Veldhoven (NL); SCHEFFERS, Paul, IJmert, 5500 AH Veldhoven (NL); GROUWSTRA, Olav, Ruben, 5500 AH Veldhoven (NL); BROOKS, Joseph, Thomas, 5500 AH Veldhoven (NL); DANIELS, Wouter, 5500 AH Veldhoven (NL); SAHIN, Ezgi, 5500 AH Veldhoven (NL); DE LEON ARIZPE, Israel, 5500 AH Veldhoven (NL); ROSCAM ABBING, Sylvianne, Dorothea, Christina, 5500 AH Veldhoven (NL); MANGNUS, Albertus, Victor, Gerardus, 5500 AH Veldhoven (NL)
(74) Representative: ASML Netherlands B.V.

(57) **Abstract**

An optical beam member for a charged particle-optical device configured to direct a charged particle beam towards a sample location, the optical beam member comprising: a charged particle beam aperture for passage of the charged particle beam, an emitter arrangement associated with the charged particle beam aperture, the emitter arrangement configured to emit an optical radiation towards the sample location, and an optical source module comprising an optical source arrangement for providing an optical radiation input to the said emitter arrangement. An assembly comprising the optical beam member. A charged particle-optical device comprising the assembly. A method for directing optical radiation towards a sample location of a sample.

## Description

### FIELD

The present invention relates to an optical beam member, an assembly for a charged particle-optical device, a charged particle-optical device, a charged particle-optical apparatus and a method for directing optical radiation towards a sample location of a sample.

### BACKGROUND

During manufacturing processes of, for example, semiconductor integrated circuit (IC) chips or displays, undesired defects may occur on a substrate (for example wafer or a mask). Such defects may reduce yield. Defects may occur as a consequence of all kinds of processing necessary to produce an integrated circuit or display, for example, lithography, etching, deposition or chemical mechanical polishing. Defects may include patterning defects, in which the created pattern lies outside the pattern tolerance for the process, and particles. Monitoring the extent of defects during the manufacturing processes is therefore important. Such monitoring (or more generally assessment) includes the determination of the existence of a defect, but also the classification of the types of defects found.

For the assessment of a sample, different types of inspection or metrology systems have been used, including charged particle systems such as electron microscopes. Such assessment for inspection may relate to defects, for example the existence and classification of such defects. Electron microscopes typically generate a probe beam (also often referred to as primary beam) which may, for example, be scanned across a part of the substrate (such as in a scanning electron microscopes (SEM)). Collecting interaction products that result from the interaction of the primary beam with the part of the substrate, allows the electron microscope to collect data representing the probed part of the substrate. The data may be processed/rendered for example by the electron microscope to generate an image representation of the part of the substrate. The collected data for example as a generated image representation allows for measuring structures on the part of the substrate, or allows for identifying defective structures by comparing the image representation with a reference. Such measurement may be referred to as metrology; the identification of defective structures may be referred to as (defect) inspection. The interaction products may contain charged particles which may be referred to as signal particles (for example signal electrons), such as secondary electrons and backscattered electrons, and may contain other interaction products, such as X-ray radiation and even light.

In the context of assessment systems, for example inspection or metrology systems, a photonic element may be used, for example, to direct optical radiation towards the sample. In order to use the photonic element to manipulate optical radiation, optical radiation may be generated using an optical source and the optical radiation is coupled into and out of the photonic element. There is a need to provide a more compact and efficient optical component for use in the compact available space in inspection or metrology systems.

### SUMMARY

An embodiment of the present disclosure provides an optical beam member for a charged particle-optical device configured to direct one or more charged particle beams towards a sample location, the optical beam member comprising: one or more charged particle beam apertures for passage of the one or more charged particle beams, an emitter arrangement associated with each charged particle beam aperture, the emitter arrangement configured to emit optical radiation towards the sample location, and an optical source module comprising an optical source arrangement for providing an optical radiation input to the said emitter arrangement.

An embodiment of the present disclosure provides an assembly for a charged particle-optical device configured to direct one or more charged particle beams toward a sample location, the assembly comprising the optical beam member of the present disclosure.

An embodiment of the present disclosure provides a charged particle-optical device configured to direct one or more charged particle beams towards a sample location, the charged particle-optical device comprising the assembly of the present disclosure.

An embodiment of the present disclosure provides a charged particle-optical apparatus comprising the charged particle-optical device of the present disclosure; and an actuatable stage configured to support a sample.

An embodiment of the present disclosure provides a method for directing optical radiation towards a sample location of a sample, the method comprising: generating optical radiation by one or more optical source arrangements of an optical source module, providing the optical radiation to an optical beam member comprising at least one emitter arrangement, each of the at least one emitter arrangements configured to emit optical radiation the sample location, wherein one or more charged-particle beam apertures are defined in the optical beam member for passage of one or more charged particle beams towards the sample, and wherein the at least one emitter arrangement is associated with a respective charged particle beam aperture.

### BRIEF DESCRIPTION OF THE DRAWINGS

Embodiments of the invention will now be described, by way of example only, with reference to the accompanying schematic drawings, in which:
- Figure 1 is a schematic diagram of an exemplary assessment apparatus;
- Figure 2 schematically depicts a multi-beam charged particle-optical device, for example of the assessment apparatus of Figure 1;
- Figure 3 schematically depicts a multi-beam charged particle-optical device, for example of the assessment apparatus of Figure 1;
- Figure 4 schematically depicts an alternative multi-beam charged particle-optical device, for example of the assessment apparatus of Figure 1;
- Figure 5 schematically depicts a charged particle-optical device array;
- Figure 6 schematically depicts a detector array in plan view;
- Figure 7 schematically depicts an optical beam member according to the present disclosure;
- Figure 8 schematically depicts an optical beam member according to the present disclosure;
- Figure 9 schematically depicts an optical beam member according to the present disclosure, having integrated optical sources and electrical wires to power the optical sources;
- Figure 10 schematically illustrates a portion of an optical beam member and a detector array according to the present disclosure.

The Figures are schematic. Within the following description of drawings, the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred to with reference to electrons, throughout the present document may therefore be more generally be considered to be references to charged particles, and items referred to in reference to charged particles, with the charged particles not necessarily being electrons. For example, references to an electron-optical device may more generally be considered to be references to a charged particle-optical device.

### DETAILED DESCRIPTION

There is a trend in the semiconductor industry (often known as "Moore's law") to reduce the physical dimensions of structures representing circuit components on a substrate and/or to increase the packing density of such structures, in order to reduce the physical size of electronic devices and/or enhance the computing power of electronic devices. The physical dimensions of such structures may be reduced and/or the packing density of such structures may be increased by increasing lithographic resolution. Manufacturing processes of semiconductor IC chips can have 100s of individual steps. An error in any step of the manufacturing process has the potential to adversely affect the functioning of the electronic device. It is desirable to improve the overall yield of the manufacturing process. For example, to obtain a 75% yield for a 50-step manufacturing process (where a step may indicate the number of layers formed on a substrate), each individual step must have a yield greater than 99.4%. If an individual step has a yield of 95%, the overall yield of the manufacturing process would be as low as 7.7%. It is desirable to determine defects quickly so as to maintain a high substrate throughput, defined as the number of substrates processed per hour.

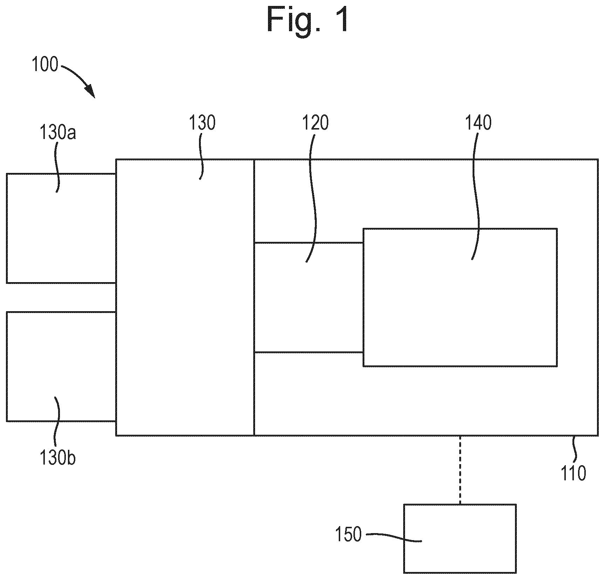

Figure 1 is a schematic diagram illustrating an exemplary assessment apparatus 100, for example a metrology apparatus or an inspection apparatus. The assessment apparatus 100 may be configured to scan a sample with one or more beams of electrons. The sample may be a semiconductor substrate, a substrate made of other material, or a mask, for example. The electrons interact with the sample and generate interaction products. The interaction products comprise signal electrons, for example secondary electrons and/or backscattered electrons, and possibly X-ray radiation. The assessment apparatus 100 may be configured to detect the interaction products from the sample so that a data set may be generated which may be processable into an image or any other data representation of the scanned area of the sample. For clarity, the description below focuses on embodiments in which the interaction products that are detected are signal electrons. The assessment apparatus 100 may comprise, for example during operation, a single beam or a plurality of beams, that is a multi-beam. The component beams of a multi-beam may be referred to as sub-beams or beamlets. A multi-beam may be used to scan different parts of a sample simultaneously. When the assessment apparatus 100 uses a multi-beam, the assessment apparatus 100 may assess a sample more quickly than when the assessment apparatus 100 uses a single-beam. For example, a higher throughput of sample assessment may be achieved using a multibeam assessment apparatus compared to a single beam apparatus. The assessment apparatus 100 of Figure 1 comprises a vacuum chamber 110, a load lock chamber 120, an electron-optical apparatus 140, an equipment front end module (EFEM) 130 and a controller 150. The electron-optical apparatus 140 (also known as an electron beam apparatus or an electron apparatus) may be within the vacuum chamber 110. The electron-optical apparatus 140 may comprise an electron-optical device (described in more detail below) and an actuatable stage. It should be appreciated that reference in the description to the electron-optical elements of the electron-optical apparatus 140 can be considered to be a reference to the electron-optical device.

The EFEM 130 includes a first loading port 130a and a second loading port 130b. The EFEM 130 may include additional loading port(s). The first loading port 130a and the second loading port 130b may, for example, receive substrate front opening unified pods that contain samples. One or more robot arms (not shown) in the EFEM 130 transport the samples to the load lock chamber 120.

The load lock chamber 120 is used to remove the gas around a sample. The load lock chamber 120 may be connected to a load lock vacuum pump system (not shown), which removes gas particles in the load lock chamber 120. The operation of the load lock vacuum pump system enables the load lock chamber to reach a first pressure below the atmospheric pressure. The vacuum chamber 110, which may be a main chamber of the assessment apparatus 100, is connected to a main chamber vacuum pump system (not shown). The main chamber vacuum pump system removes gas molecules from the vacuum chamber 110 so that the pressure around the sample reaches a second pressure equal to or lower than the first pressure. Different parts of the electron-optical apparatus 140 may have different levels of pressure below the atmospheric pressure. After reaching the required pressure, the sample leaves the load lock chamber 120 and is transported to the electron-optical apparatus 140 by which it may be assessed. The electron-optical apparatus 140 may use either a single beam or a multi-beam for the assessment. Alternatively, an electron-optical device array comprising a plurality of electron-optical devices may be used, further also referred to as a multi-column electron-array, in which each electron-optical device (or each column in the multi-column array) comprises, for example during operation, either a single beam or a multi-beam.

The controller 150 is electronically connected to the electron-optical apparatus 140. The controller 150 may be a processor (such as a computer) configured to control the assessment apparatus 100. The controller 150 may also include processing circuitry configured to execute data, signal and image processing functions for example on the data set for example embodied as signals such as detection signals. The controller 150 may thus include processing circuitry configured to execute processing functions on signal, image and other data produced in the assessment apparatus 100. While the controller 150 is shown in Figure 1 as being outside of the structure that includes the vacuum chamber 110, the load lock chamber 120, and the EFEM 130, it is appreciated that the controller 150 may be part of the structure. The controller 150 may be located in one of the components of the assessment apparatus 100 or it may be distributed over at least two of the components.

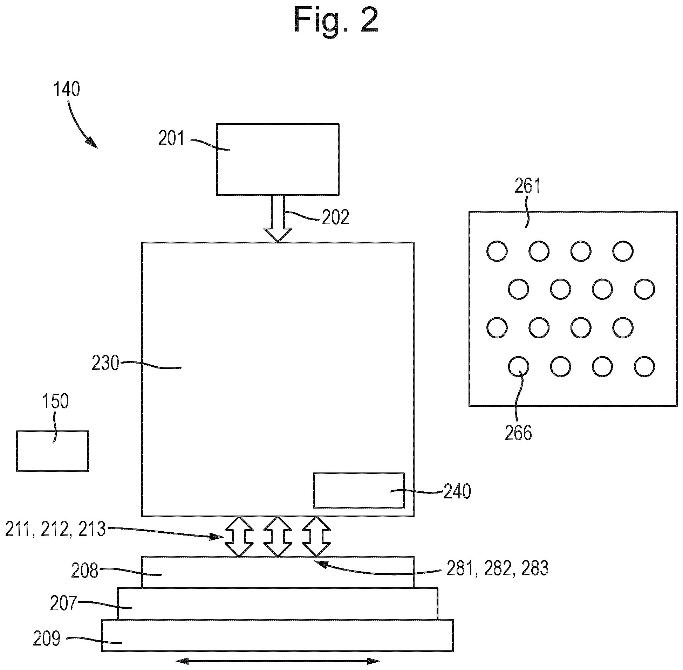

Figure 2 is a schematic diagram illustrating an exemplary electron-optical apparatus 140. The electron-optical apparatus 140 may be provided as part of the assessment apparatus 100 of Figure 1. The electron-optical apparatus 140 includes a source 201 and an electron-optical device 230 (which may also be referred to as an electron-optical column). The source 201 may comprise a cathode (not shown) and an extractor and/or anode (not shown). During operation, the source 201 is configured to emit electrons from the cathode. The electrons may be extracted or accelerated by the extractor and/or the anode to form the source beam 202.

The electron-optical device 230 may be configured to convert the source beam 202 into a plurality of primary beams 211, 212, 213 (which may be referred to as sub-beams or beamlets). The electron-optical device 230 may be configured to direct the primary beams 211, 212, 213 along respective beam paths toward a sample location for the sample 208. Although three beams are illustrated, the number of beams may be of the order of 100s or 1,000s, for example up to 20,000 per electron-optical apparatus 140. The plurality of beams may be referred to collectively as a multi-beam or a beam grid. The different beams may be arranged relative to each other across the beam grid in a pattern. The pattern of the beam grid may be referred to as an array. The electron-optical device 230 has a field of view which may be defined as the area of the surface of the sample 208 within which the primary beams 211, 212, 213 can scan while the aberrations of the electron-optical device 230 remain within a defined value. Alternatively, the field of view may be defined by the maximum scan range of the electron-optical device 230. The field of view may be of the order of millimeters, for example up to 20mm at the sample 208.

The electron-optical device 230 comprises a plurality of electron-optical elements positioned along the beam paths. The electron-optical elements are configured to manipulate the beams. For example, the electron-optical elements may be configured to lens, focus, deflect or correct the beams. The electron-optical elements may be arranged in at least one stack of electron-optical elements. Such an electron-optical element may be positioned upbeam or downbeam with respect to another of the electron-optical elements. The terms upbeam and downbeam relate to the direction of the beams from the source 201 to the sample 208 during use of the electron-optical device 230, which may be expressed as a direction along one or more of the beam paths. In an embodiment some of the different electron-optical elements may take a planar form, such as a plate 261. An electric field that manipulates the beams may be generated between two plates 261, for example by applying, in use, different potentials to neighboring/adjoining plates 261 such as along the beam path. An electric field that manipulates the beams may be generated between surfaces of plates 261 across the beam path for example between the neighboring plates 261. One or more beam apertures 266 may be defined in the plates 261 for the passage of one or more beams. The beam apertures 266 may be arranged in a pattern such as a regular grid for example hexagonal or square. Such a pattern of the beam apertures 266 may be referred to as an aperture array (that is a two-dimensional array over the surface of the plate). The pattern of the beam apertures 266 may correspond to the pattern of beams within the beam grid. Beam apertures 266 in different plates operating on the same beam(s) are typically aligned.

The electron-optical elements may comprise one or more corrector arrays. For example, a corrector array may be integrated into the shape, position and/or size of the beam apertures 266 of the plates 261. The disclosure of such a corrector array as described in WO 2022101072 A1 is hereby incorporated by reference. One or more corrector arrays may comprise multipole deflectors with a specific superposition of potentials applied across the individually controllable electrodes. The disclosure in WO2012165955 of an array of multipole deflectors is hereby incorporated by reference.

One or more of the electron-optical elements may comprise an aperture for the path of a plurality of the beams. For example, the aperture may be a macro aperture for all of the beams. The disclosures of a slit aperture for a collimator or corrector comprising strip electrodes in WO 2021156121 A1 and WO 2021204734 A1 are hereby incorporated by reference. One or more electron-optical elements may comprise one or more plate electrodes that are curved across the path of the beam grid for use as a lens array, a corrector array and/or a collimator array such as disclosed in European patent application 23211553.5 filed 22 November 2023, which is hereby incorporated by reference at least so far as the use and application of curved plate electrodes.

**In** the current embodiment, the electron-optical device 230 may form three probe spots 281, 282, 283 on the surface of the sample 208. The electron-optical device 230 may be configured to deflect the primary beams 211, 212, 213 so as to scan the probe spots 281, 282, 283 across individual scanning areas of the sample 208. In response to incidence of the primary beams 211, 212, 213 on the sample 208, signal electrons are generated from the sample 208, which may include secondary electrons and backscattered electrons. Secondary electrons typically have electron energy of at most 50 eV. Backscattered electrons typically have electron energy of more than 50 eV and less than the landing energy of the primary beams 211, 212, 213.

The electron-optical apparatus 140 comprises a sample holder 207 that supports a sample 208. The sample holder 207 supports the sample 208 for assessment. The sample holder 207 is supported by an actuatable stage 209. The electron-optical apparatus 140 further comprises a detector array 240. The detector array 240 may be part of the electron-optical device 230. The detector array 240 for example detects signal electrons from the sample 208. The detector array 240 generates detection signals based on detection of the signal electrons.

**In** an embodiment, the detector array 240 may define the surface of the electron-optical apparatus 140 facing the sample 208, for example the bottom surface of the electron-optical device 230. There may be more than one detector array at different positions along the paths of the primary beams 211, 212, 213.

The detector array 240 may comprise a plurality of detector elements, with at least one detector element per beam. The detector elements may, for example, be charge capture electrodes, for example metal plates, which may be configured to detect at least some of the signal electrons. Alternatively or additionally, the detector elements may comprise detection diodes configured to detect at least some of the signal electrons. Alternatively or additionally, the detector elements may comprise a scintillator material (such as YAG) configured to convert signal electrons into photons that may be subsequently detected. The detector elements may be arranged around beam apertures 266 in the bottom surface of the electron-optical device 230 to allow the primary beams 211, 212, 213 to pass towards the sample 208. Each detector element may comprise a plurality of detection segments or may constitute a single sensitive surface for each beam. The detection signal generated by a detector element may be transmitted to a processor for generation of an image. For example, the detection signal may represent a grey value or an intensity value of a pixel of an image.

The detector array 240 may send the detection signals, for example as an imaging signal or a detection signal, to the controller 150 or to a signal processing system (not shown) which may be part of the controller 150. The controller 150 or the signal processing system may be configured to generate images of the corresponding scanned areas of the sample 208. The detector array 240 may be incorporated at least partly into the electron-optical device 230. Alternatively, the detector array 240 may be separate from the electron-optical device 230. For example, the electron-optical apparatus 140 may comprise a secondary electron-optical device configured to direct secondary electrons to the detector array 240. In such an embodiment, the secondary electron-optical device comprises a beam separator (such as a Wien filter, not shown). The beam separator may separate the paths of the primary electrons towards the sample 208 from the paths of the signal electrons away from the sample 208. Note, such a beam separator may be present in a different embodiment with a detector array within the electron-optical device 230 for directing the primary electrons towards the sample and the signal particles to detector elements of the detector array.

The controller 150 (for example a control system comprising distributed controllers) may be connected to various parts (for example components) of the electron-optical apparatus 140 of Figure 2, such as the source 201, the detector array 240, the electron-optical device 230, and the actuatable stage 209. The controller 150 may perform various image processing functions and signal processing functions. The controller 150 may also generate various control signals to govern operations of the assessment apparatus 100.

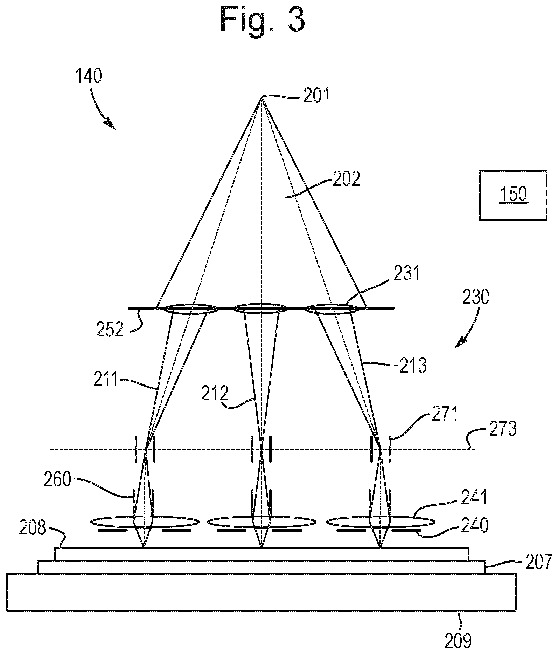

Figure 3 schematically depicts an electron-optical apparatus 140 of an assessment apparatus, for example the assessment apparatus 100 of Figure 1. The electron-optical apparatus 140 of Figure 3 may be the electron-optical apparatus 140 of Figure 2 in which the electron-optical elements of the electron-optical device 230 comprise a beam limiting aperture array 252, a condenser lens array 231, a collimator array 271 desirably at an intermediate focus plane 273, a scan deflector array 260, an objective lens array 241 and the detector array 240.

The source 201 generates a diverging source beam 202. The beam limiting aperture array 252 defines a plurality of primary beams 211, 212, 213 from the source beam 202. The condenser lens array 231 focuses the primary beams 211, 212, 213 at the intermediate focus plane 273. The condenser lens array 231 may comprise the beam limiting aperture array 252. Alternatively, the condenser lens array 231 may be downbeam of the beam limiting aperture array 252. The condenser lens array 231 may be electrostatic. In an alternative embodiment the condenser lens array 231 comprises a magnetic element for example as a plurality of magnetic elements / one or more magnetic elements.

The collimator array 271 is configured to collimate the primary beams 211, 212, 213 along respective beam paths towards and substantially orthogonal to a surface of the sample 208. The collimator array 271 may be located at or near the intermediate focus plane 273. The collimator array 271 may comprise a plurality of deflectors configured to deflect respective primary beams 211, 212, 213. Additionally or alternatively the collimator array 271 may comprise a lens array that operates on the different beams to deflect the relative paths of the beams. The collimator array 271 may be electrostatic. The collimator array 271 may consist of a single plate 261 comprising electrodes around the beam apertures 266, such as on the surface around the beam apertures 266 and/or on the inside of the beam apertures 266. The electrodes may cooperate as a deflector per beam aperture 266. Alternatively, the collimator array 271 may comprise a stack of plates 261. In use a potential difference is applied between the plates 261 so as to generate a lensing effect at the beam apertures 266. The plates 261 may have a curvature across the beam path. Alternatively, the collimator array 271 may comprise a plurality of layers of strip electrode deflectors as shown in WO2021156121 and WO2021204734. A layer of strip electrode deflectors may consist of a plate. Although not shown in Figure 3, in an alternative embodiment the collimator array 271 is replaced by a macro collimator configured to collimate the primary beams 211, 212, 213. The macro collimator may be a magnetic lens, or an electrostatic lens, or a combination of magnetic and electrostatic lens. In a further alternative embodiment, the electron-optical device 230 comprises a macro collimator in addition to the collimator array 271.

The deflectors of the scan deflector array 260 may be formed at apertures of the scan deflector array 260. The deflectors may comprise respective sets of individually controllable electrodes. Such a deflector may be referred to as a multipole deflector. The individually controllable electrodes extend partially along the beam path of the respective beam. The individually controllable electrodes may be controlled to generate, in use, a scan movement of the respective beam across the sample 208. Typically, the sets of individually controllable electrodes operate to scan all of the primary beams 211, 212, 213 simultaneously in parallel across the individual fields of view of the respective objective lenses of the objective lens array 241. Alternatively, the scan deflector array 260 may comprise strip deflectors (as shown in WO2004081910, WO2021156121 and WO2021204734) configured to deflect a row of beams along the individual fields of view of the respective objective lenses of the objective lens array 241.

The objective lens array 241 is configured to focus the primary beams 211, 212, 213 onto the sample 208. The objective lens array 241 may comprise a stack of plates 261. Different potentials are applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The stack of plates 261 of the objective lens array 241 may be referred to as, or as part of, an objective lens assembly. The objective lens assembly may comprise one or more of the scan deflector array 260, a corrector array (not shown) and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, a condenser lens array, a collimator array, an objective lens array and a detector array are hereby incorporated by reference.

The electron-optical device 230 may comprise one or more corrector arrays configured to at least partly correct one or more types of aberration of the beams. Such corrector arrays may be associated with or integrated into the condenser lens array 231, the collimator array 271 and/or the objective lens array 241, or between two of these arrays, for example between the condenser lens array and the collimator array.

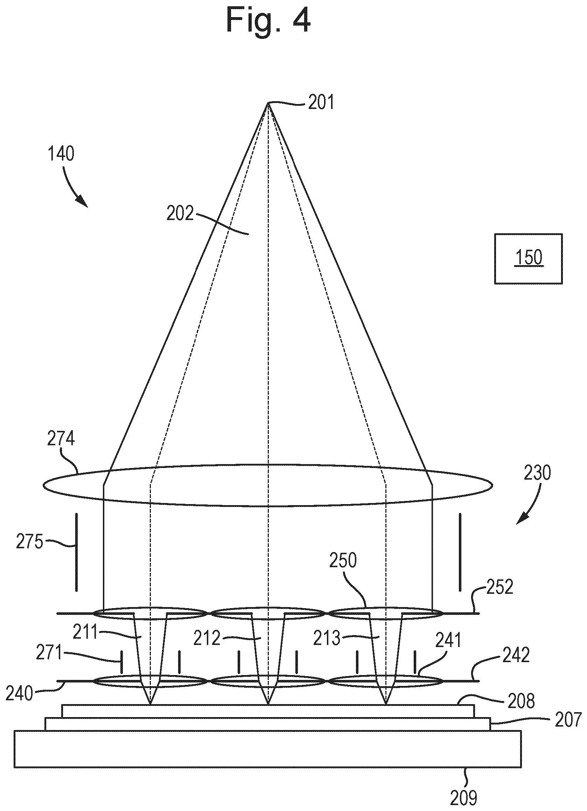

Figure 4 schematically depicts an electron-optical apparatus 140 of an assessment apparatus, for example the assessment apparatus 100 of Figure 1. The electron-optical apparatus 140 of Figure 4 may be the electron-optical apparatus 140 of Figure 2 in which the electron-optical device 230 comprises a macro condenser lens 274, a macro scan deflector 275, a beam limiting aperture array 252 (which may be referred to as an upper beam limiter), a control lens array 250, a collimator array 271, an objective lens array 241, a beam shaper array 242 (which may be referred to as a lower beam limiter) and the detector array 240.

The source 201 generates a diverging source beam 202. The macro condenser lens 274 is located between the source 201 and the objective lens array 241. The macro condenser lens 274 is configured to at least partly collimate the source beam 202. The macro scan deflector 275 is located between the macro condenser lens 274 and the objective lens array 241. The macro scan deflector 275 is configured to operate on the source beam 202 so that the primary beams 211, 212, 213 scan the surface of the sample 208. Additionally or alternatively the electron-optical device 230 may comprise a scan deflector array (not shown) downbeam of the control lens array 250. The macro condenser lens 274 and/or the macro scan deflector 275 may at least in part be magnetic.

The beam limiting aperture array 252 defines a plurality of primary beams 211, 212, 213 from the source beam 202. The beam shaper array 242 and the beam limiting aperture array 252 are plates 261 in which the beam apertures 266 are smaller in dimension than other plates of the electron-optical device 230. The beam apertures 266 of the beam limiting aperture array 252 define the primary beams 211, 212, 213. The beam apertures 266 of the beam shaper array 242 shape the primary beams 211, 212, 213 to at least partially correct for types of aberration in the beams.

The collimator array 271 is configured to collimate the primary beams 211, 212, 213 along respective beam paths towards and substantially orthogonal to a surface of the sample 208. The collimator array 271 may be located between the beam limiting aperture array 252 and the objective lens array 241. The collimator array 271 may be omitted. Alternatively, when the collimator array 271 is provided, then the macro condenser lens 274 may be omitted. The collimator array 271 may comprise a plurality of deflectors configured to deflect respective primary beams 211, 212, 213. The collimator array 271 may be electrostatic. The collimator array 271 may consist of a single plate 261 comprising the deflectors around the beam apertures 266, for example on the surface around the beam apertures 266 and/or on the inside of the beam apertures 266. Alternatively, the collimator array 271 may comprise a stack of plates 261. In use a potential difference is applied between the plates 261 so as to generate a lensing effect at the beam apertures 266. One or more of the plates may be curved across the path of the beam grid. Alternatively or additionally, the collimator array 271 may comprise a plurality of layers of strip electrode deflectors. A layer of strip electrode deflectors may be a plate.

The objective lens array 241 is configured to focus the primary beams 211, 212, 213 onto the sample 208. The objective lens array 241 may comprise a stack of plates 261. In use, different potentials may be applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The control lens array 250 may be upbeam of the objective lens array 241. The control lens array 250 may comprise a stack of plates 261, for example at least three plates 261. The control lens array 250 may be configured to control electron-optical parameters of the primary beams 211, 212, 213. In an embodiment, the most downbeam plate of the control lens array 250 is the most upbeam plate of the objective lens array 241. Alternatively, the control lens array 250 may be considered to be part of the objective lens array 241. The control lens array may provide one or more additional degrees in electron-optical freedom such as in pre-focusing, magnification and beam current setting.

The stack of plates 261 of the objective lens array 241 may be referred to as an objective lens assembly. The objective lens assembly may comprise one or more of the beam limiting aperture array 252, the control lens array 250, a corrector array (not shown), the collimator array 271, the beam shaper array 242 and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, an objective lens array and a detector array are hereby incorporated by reference. The disclosure in WO2022058252 A1 of the collimator array, the macro condenser lens, the macro scan deflector, and the need for a beam limiting aperture array and a beam shaper array is incorporated by reference.

The electron-optical device 230 may comprise one or more corrector arrays (not shown) configured to at least partly correct one or more types of aberration of the beams. Such corrector arrays may be associated with or integrated into the control lens array 250, the collimator array 271 and/or the objective lens array 241, for example as part of the objective lens assembly. While Figures 3 and 4 show two embodiments of the multi-beam electron-optical apparatus 140 in Fig. 2, other implementations of a multi-beam electron-optical apparatus are also possible.

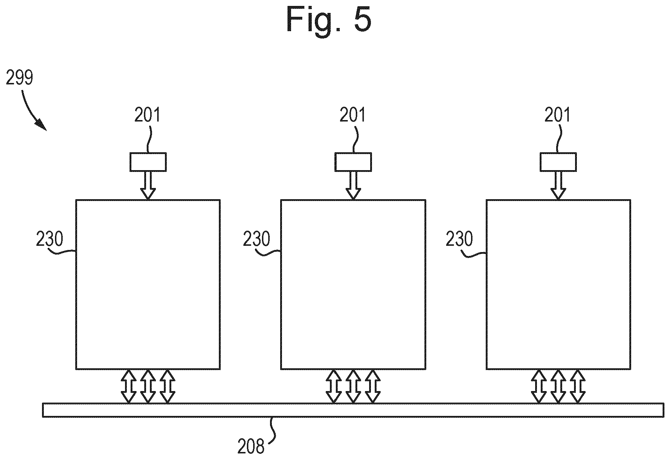

Figure 5 schematically depicts an electron-optical device array 299. In an embodiment the assessment apparatus 100 of Figure 1 comprises the electron-optical device array 299 instead of the electron-optical apparatus 140. Such an electron-optical device array 299 is also referred to as a multi-column array. The different columns (or electron-optical devices 230) may comprise in use a plurality of beams such as a beam grid. In an embodiment the electron-optical device array 299 comprises a plurality of electron-optical devices 230 of the type shown in Figure 2.

In an embodiment, one or more electron-optical elements may be shared between more than one of the electron-optical devices 230 of the electron-optical device array 299. The electron-optical elements may comprise one or more plates 261 in which a plurality of beam apertures 266 are defined for respective beam paths. In an embodiment, one or more sources 201 may be shared between more than one of the electron-optical devices 230 of the electron-optical device array 299. The sources may be comprised in a source array having different sources generating a source beam for different respective electron-optical device 230.

The electron-optical devices 230 may focus respective multi-beams simultaneously onto different regions of the same sample 208. In a different embodiment, the electron-optical devices 230 of the electron-optical device array 299 may project respective single beams towards the sample 208.

Each electron-optical device 230 of the electron-optical device array 299 may be configured in any of the ways described herein. The disclosure in WO 2022008286 A1 of how the objective lens is incorporated and adapted for use in the multi-device arrangement is hereby incorporated by reference. The disclosure in WO 2021165135 A1 of a multi-device arrangement of a multi-beam device comprising a collimator at, or proximate to, an intermediate focus is hereby incorporated by reference.

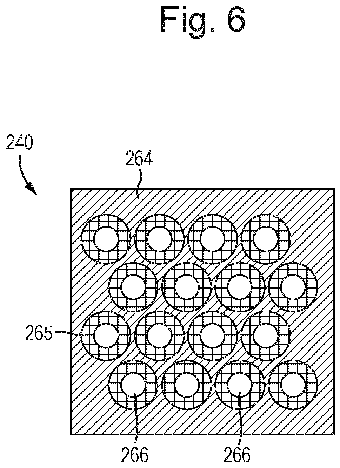

Figure 6 is a bottom view of the detector array 240 which comprises a detector substrate 264 on which are provided a plurality of detector elements 265 each surrounding a beam aperture 266. The detector array 240 may be provided at a downbeam surface of a plate 261 comprising beam apertures 266. In an embodiment, the detector elements 265 are charge capture electrodes, for example metal plates. The beam apertures 266 may be formed by etching through the detector substrate 264. In the arrangement shown in Figure 6, the beam apertures 266 are in a hexagonal close packed array. The beam apertures 266 can also be differently arranged, for example, in a rectangular array.

A charged-particle optical device may comprise a photonic element used to manipulate optical radiation. In particular, a photonic element may be employed to manipulate the optical radiation and direct optical radiation to other components and/or modules in a system where the manipulated light is further to be utilized. In the context of the charged particle-optical device, for example as described above in reference to any of Figure 1 to Figure 6, a photonic element may be used to direct optical radiation towards the sample 208 or sample location. For example, where the charged particle-optical device 230 is an electron-optical device, one or more electron beams scan the sample 208. A photonic element integrated into the charged particle-optical device may be configured to receive optical radiation from an external optical source and to illuminate the sample 208 with the optical radiation in order to improve defect contrast during defect inspection. This technique, which may be referred to as voltage contrast imaging, may be used to measure whether there is a proper electrical connection between a contact and the substrate of the sample 208. The photonic element may be configured to manipulate optical radiation on a planar circuit. The planar circuit may be an integrated optical circuit, such as a photonic integrated circuit. In order to use the photonic element to manipulate optical radiation, optical radiation may be generated using an external optical source and the optical radiation is then coupled into and out of the photonic element.

The external optical source may comprise, for example, a laser connected to an optical fibre. The optical fibre may be used to couple the optical source to the photonic element, so that optical radiation may be input into the photonic element and subsequently directed towards the sample location. Coupling of an external optical fibre to the photonic element may present a number of challenges. For example, the complexity of coupling external optical fibres to the photonic element may result in unsecured fibre ends. The process of aligning individual optical fibres to the photonic element can be challenging and may result in alignment inaccuracies. For example, in some implementations, the optical source may be coupled to the photonic element via multiple optical fibres, each fibre being configured to provide optical radiation to a respective waveguide of the photonic element. Aligning each of multiple optical fibres to respective waveguides may be particularly challenging due to the alignment accuracy required to ensure optimal coupling efficiency. The external optical source may be located outside the main vacuum chamber of the assessment apparatus. Use of additional optical elements between the optical source and the photonic element, for directing the optical radiation into the photonic element, may lead to a degradation of the optical radiation (for example, loss of power).

Furthermore, due to the limited volume of the charged particle-optical device, there is a practical limitation on the size of additional components, including optical fibres and their associated coupling elements, that can be incorporated into the device. This size constraint may impose an upper bound on the size of additional components, thereby precluding the utilization of more powerful optical sources, which in turn limits the achievable optical radiation power that can be delivered to the sample.

The present invention provides an optical beam member which may be used in a charged particle-optical device for providing optical radiation to a sample or a sample location. According to the present invention, the optical beam member does not rely on external fibres, meaning that the above-described problems, associated with coupling of external optical sources to the photonic element, are avoided.

According to a first aspect of the invention, an optical beam member is provided for a charged particle-optical device configured to direct one or more charged particle beams towards a sample location. The optical beam member accordingly includes one or more charged particle beam apertures for passage of the one or more charged particle beams, an emitter arrangement associated with each charged particle beam aperture, the emitter arrangement configured to emit optical radiation towards the sample location, and an optical source module including an optical source arrangement for providing an optical radiation input to the said emitter arrangement. In other words, the optical source module is configured to emit optical radiation and input the optical radiation directly to the optical beam member. This provides a simpler, more compact and more robust assembly for the photonic element which can be handled with ease. The removal of additional coupling elements, such as optical fibres, simplifies the management of the optical beam member by reducing system complexity and potential points of failure. This simplification leads to a more user-friendly setup and decreases the likelihood of misalignment-related errors associated with aligning fibres to the photonic element. Additionally, omitting the need for coupling components enhances alignment accuracy between the optical source module and the optical beam member, improving overall system performance and reliability. The optical source module may be provided within the vacuum chamber of the assessment apparatus.

The optical beam member may be described as being close-coupled to the optical source module. Close-coupling means that the optical beam member and the optical source module are positioned in close proximity to each other. Desirably, no additional components are present in an optical path between the optical beam member and the optical source module, with the possible exception of an impedance matching layer(s). Close-coupling facilitates efficient transfer of optical energy between the components and may minimise losses due to scattering, reflection, or divergence of the optical signal. The optical beam member and the optical source module may be integrated, for example they may be implemented using hybrid integration or direct integration (described in more detail later). Alternatively, the optical beam member and the optical source module may be implemented as detachable modules (described in more detail later).

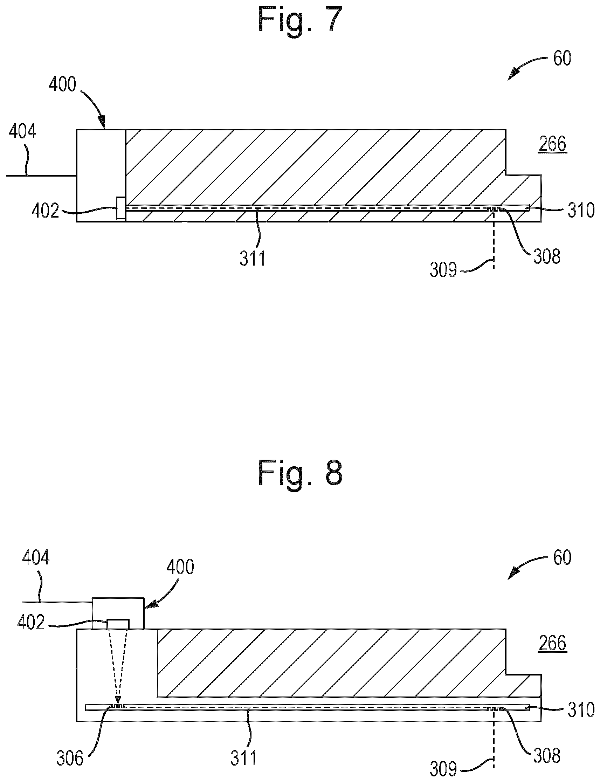

Figures 7 to 10 schematically depicts arrangements related to an optical beam member 60 for a charged particle-optical device 230, such as described above in reference to Figures 1 to 6.

The optical beam member 60, for example as shown in Figure 7, comprises a charged particle beam aperture, such as one of the beam apertures 266 described with reference to Figure 2. Figure 7 shows a portion of a cross-section of the beam aperture 266, the cross-section taken through a plane containing the charged-particle optical axis. A charged particle beam may be directed through the charged particle beam aperture 266 towards a sample or sample location disposed downbeam of the charged particle beam (the sample is not shown in Figure 7). The optical beam member 60 comprises an optical source module 400. The optical source module 400 comprises an optical source arrangement 402 which generates optical radiation and inputs the optical radiation to the optical beam member 60. The optical source module 400 may be connected to a power supply via wiring 404.

The optical beam member 60 comprises an emitter arrangement 308 associated with the charged particle beam aperture 266, the emitter arrangement 308 configured to emit optical radiation 309 towards the sample location. The emitter arrangement 308 may be configured to emit optical radiation 309 by outcoupling the optical radiation input 311 (provided by the optical source module 400). The emitter arrangement 308 may emit optical radiation toward the sample location to facilitate with voltage contrast assessment of a sample. Possible geometrical configurations of emitter arrangement 308, as well as the type of emitter arrangement 308, are described in greater detail below.

The optical source module 400 and the optical beam member 60 may be integrated. In other words, they may be provided as a single component which, in turn, can be integrated into a charged particle-optical device 230. The optical source module 400 and the optical beam member 60 may be connected together before installation into the assessment apparatus. This installation can be the setup of the assessment apparatus comprising the optical beam member 60, by allowing the optical source module 400 and the optical beam member 60 to be installed as a single, integrated component within the vacuum chamber of the assessment apparatus. This advantageously eliminates the need to direct optical radiation from an external source disposed outside the vacuum chamber to the photonic element within the vacuum chamber. In other words, when the optical beam member 60 may be provided in assessment apparatus 100, meaning the optical source module 400 of the optical beam member 60 may be disposed within the vacuum chamber 110 of the assessment apparatus 100. This is in contrast to systems, in which the source of optical radiation (such as an optical source module) is provided outside the vacuum chamber. The optical source module 400 and the optical beam member 60 may be a single component that is replaceable as a unit.

An integrated optical source module 400 and optical beam member 60 may be manufactured via hybrid integration. Hybrid integration comprises technologies in which a device is assembled from multiple substrates using packaging techniques such as die-attach and soldering in order to unite components with various capabilities in a single device. For example, the optical source module 400 and the optical beam member 60 may be manufactured on separate substrates and then bonded. Prior to bonding, the optical source module 400 and the optical beam member may be aligned at respective interfaces to facilitate efficient optical coupling between chip. For example, an optical source of the optical source module 400 may be aligned with a waveguide 310 prior to bonding, or each of a plurality of optical sources may be aligned with respective waveguides 310 prior to hybrid bonding.

An integrated optical source module 400 and optical beam member 60 component may be manufactured by aligning the optical source module 400 and optical beam member 60 and then attaching them. Any suitable attachment method may be employed, such as adhesion. Adhesion may comprise providing an adhesive between the optical source module 400 and the optical beam member 60. It may be desirable to match refractive indices of the optical source module 400 and the optical beam member 60 to select materials of the optical source module 400 and the optical beam member 60 which have the same refractive indices. If an adhesive is used to attach the optical source module 400 and the optical beam member 60, the adhesive may be selected so that it has the same refractive index as at least one of the optical source module 400 and the optical beam member 60. This may prevent undesired power losses, for example, due to optical radiation being reflected at the interface between any two of the optical source module 400, optical beam member 60, and if applicable, the adhesive, thus reducing loss of optical radiation 311.

An integrated optical source module 400 and optical beam member 60 may be manufactured by direct integration, such as heterogeneous integration or monolithic integration. Heterogeneous integration describes technologies by which disparate materials are united on a single substrate via wafer bonding techniques. Multilayer heterogeneous integration may utilize an intermediate layer (such as a silicon layer) between the optical source and the waveguide, as there may be a mismatch between the refractive index of the optical source (such as the gain material of a laser) and the refractive index of the waveguide.

An integrated optical source module 400 and optical beam member 60 may be manufactured by monolithic integration. Monolithic integration involves on-chip integration of the optical source to the optical beam member 60. In contrast to heterogenous integration, monolithic integration may not require use wafer bonding techniques.

The optical source module 400 and the optical beam member 60 may be operatively detachable. In other words, the optical beam member 60 and optical source module 400 may be provided as separate components which may cooperate to couple optical radiation emitted by the optical source arrangement 402 to the emitter arrangement 308. It may be desirable to match refractive indices of the optical source module 400 and the optical beam member 60 and to select materials of the optical source module 400 and the optical beam member 60 which have the same (at least substantially similar) refractive indices. This may prevent optical radiation from being reflected at the interface between any two of the optical source module 400 and optical beam member 60.

Index matching of the optical beam member 60 and the optical source arrangement 402 may be employed so that optical radiation 311 propagates from the optical source arrangement 402 to the emitter arrangements 308 without reflection. In practice, it is preferable to maximise transmission of the optical radiation 311 as it propagates from a material of one refractive index to a material of a different refractive index.

The optical beam member 60 may comprise at least one waveguide 310 for receiving the optical radiation input from the optical source module 400 and coupling the optical radiation 311 to the emitter arrangement 308. The optical radiation may propagate along the waveguide 310 to said emitter arrangement 308. The emitter arrangement 308 may be arranged to outcouple optical radiation from the waveguide 310 towards the sample location. For example, as shown in Figure 7, input optical radiation 311 may be outcoupled to the sample as optical radiation 309. While Figure 7 shows one waveguide 310 comprising one emitter arrangement 308, the optical beam member 60 may comprise further waveguides. For example, a plurality of waveguides may be oriented along various directions within a plane of the optical beam member 60 for guiding the input optical radiation towards respective emitter arrangement(s).

In one embodiment, the optical source arrangement 402 may include one optical source. In another embodiment, the optical source arrangement 402 may include a plurality or an array of optical sources. The optical source or the plurality of optical sources may comprise a solid-state laser. A solid-state laser is a type of laser that uses a solid material as its gain medium. The optical source or the plurality of optical sources may comprise a semiconductor laser - a laser which uses a semiconductor as its gain medium. The optical source or the plurality of optical sources may comprise at least one of an electrically-pumped laser or an optically-pumped laser. An electrically-pumped laser may rely on an electric current to excite the gain medium, while an optically pumped laser may rely on optical radiation from another source to excite its gain medium. The optical source or the plurality of optical sources may comprise edge-emitting lasers or surface-emitting lasers, such as vertical cavity surface emitting laser (VCSEL) or a photonic-crystal surface emitting laser (PCSEL). The optical source or the plurality of optical sources may comprise an external cavity emitting laser. An external cavity emitting laser is a laser system in which the optical resonator (the cavity that defines the laser's operating wavelength and spectral properties) is extended beyond the active gain medium (typically a semiconductor diode) to include one or more external optical elements.

An array of optical sources comprises a plurality of optical sources. The optical sources may be configured to input optical radiation to the optical beam member 60, so that the emitter arrangement 308 can emit optical radiation towards the sample location. The emitter arrangement 308 may outcouple optical radiation towards the sample location. For example, the optical radiation from each of the optical sources may be directed to a respective emitter arrangement 308 along a respective waveguide 310 of the optical beam member 60. An optical source module 400 comprising an array of optical sources may be integrated with the optical beam member 60 or it may be implemented as a detachable unit.

For example, the optical source module 400 may comprise a plurality of optical sources, wherein each optical source is configured to input optical radiation to an associated waveguide. There may be at least one optical source associated with each waveguide. In an embodiment, it is preferred for each of the optical sources to provide coherent optical radiation such that emitter arrangements coupled to or associated with a respective optical source are configured to receive coherent optical radiation.

Each optical source of the optical source arrangement 402 may be coupled to the optical beam member 60 by appropriate means, such as by edge-coupling (for example butt-coupling) each optical source to the respective waveguide 310. Edge coupling may refer to aligning and bringing into contact the end faces optical components to ensure effective transmission of optical radiation from one component to the next.

Each optical source of the optical source arrangement 402 may be coupled to the optical beam member via evanescent coupling. Evanescent coupling may refer to coupling two optical components so that optical radiation is transferred between the components through overlap of their evanescent fields.

The optical sources of the optical source arrangement 402 may be coupled to the optical beam member 60 by an optical radiation manipulating arrangement. The optical radiation manipulating arrangement may be configured to direct and/or focus optical radiation towards the emitter arrangement 308. The optical radiation manipulating arrangement may be provided to direct and/or focus optical radiation towards at least one waveguide which in turn is configured to couple light into at least one respective emitter arrangements. In this way, the optical radiation from the one or more optical sources can be more efficiently directed towards the emitter arrangements. An optical radiation manipulating arrangement may be configured to manipulate optical radiation from a single optical source or from a plurality of optical sources. Each optical source may have a respective optical radiation manipulating arrangement. Alternatively, multiple optical sources may be coupled to an optical radiation manipulating arrangement.

The optical radiation manipulating arrangement may be a lensing structure, such as a micro-lensing structure. The lensing structure may be a diffractive structure configured to direct the optical radiation, generated and emitted by a respective optical source towards the emitter arrangement 308. The optical radiation manipulating arrangement may optionally comprise a combination of structures, for example, there may be provided a combination of micro-lenses and diffraction elements to focus and/or direct the optical radiation beam.

The optical radiation manipulating arrangement may be provided adjacent each optical source - for example, the optical radiation manipulating arrangement may be provided below or downbeam of each optical source, and manipulate the optical radiation output therefrom before the optical radiation is directed toward the emitter arrangement 308. For example, the optical radiation manipulating arrangement may manipulate the radiation (direct/focus) to the waveguide 310. When the optical source module 400 is operatively detachable from the optical beam member 60, the presence of optical radiation manipulating structures may be particularly advantageous as they may couple optical radiation from the optical source module 400 to the optical beam member 60.

The emitter arrangement 308 may include one or more grating couplers. For example, the emitter arrangement 308 may be a diffraction grating which outcouples optical radiation from the waveguide to the sample location. The emitter arrangement 308 may be configured to optical radiation towards the sample location such that an optical beam spot on the sample is substantially coincident with a charged particle beam spot on the sample. The emitter arrangements 308 provided in an optical beam member 60 may be the same type of emitter arrangement. Alternatively, an optical beam member 60 may be provided with different types of emitter arrangements.

Different configurations of the optical source module 400 will be described with reference to Figures 7, 8 and 9.

The optical source arrangement 402 may be arranged to emit optical radiation towards a plane of the optical beam member 60 containing the emitter arrangement 308. For example, as shown in Figure 7, the optical source arrangement 402 may be arranged to emit optical radiation along an optical path which is parallel to the plane of the optical beam member 60 which contains the emitter arrangement 308. Each optical source in an array of optical sources may be associated with a respective emitter arrangement 308. The plane of the optical beam member 60 which contains the emitter arrangement 308 may be parallel or substantially parallel to the sample 208 during inspection of the sample. An example is shown in Figure 7, in which the optical source module 400 and its optical source arrangement 402 are disposed at an edge of the optical beam member 60.

In an embodiment, the optical source arrangement 402 may contain one optical source configured to emit optical radiation which is input into an associated waveguide 310. Alternatively, the optical source arrangement 402 may comprise a plurality of optical sources and each optical source may provide an optical radiation input to a respective waveguide 310. The respective waveguides may be provided in a plane of the optical beam member 60 containing one or more emitter arrangements 308 and be configured to provide optical radiation input to the one or more emitter arrangements 308, where a respective emitter arrangement 308 is provided for each aperture 266. The respective waveguides 310 may extend along different paths in a plane of the optical beam member 60 containing the emitter arrangements 308. Figure 7 shows the optical source module 400 comprising the optical source arrangement 402 being close-coupled (for example, integrated/attached) to the optical beam member 60 such that the optical source arrangement couples to at least one waveguide 310 feeding into an emitter arrangement 308 associated with an aperture 266.

The optical source arrangement 402 is not necessarily disposed at the edge of the optical beam member 60. The one or more optical sources of the optical source arrangement 402 may be configured to emit optical radiation along an optical path which is not parallel to the plane of the optical beam member 60 containing the emitter arrangement 308. For example, the optical source arrangement 402 may be positioned up-beam of the plane of the optical beam member 60 containing the one or more emitter arrangements 308. The optical source arrangement 402 may be arranged to provide optical radiation at a non-zero angle to the plane of the optical beam member 60 containing the emitter arrangement 308. For example, the optical source arrangement 402 may emit optical radiation perpendicular to the plane of the optical beam member 60 containing the emitter arrangement 308, as illustrated schematically in Figure 8. The optical source arrangement 402 may emit optical radiation toward an in-coupler 306 of the optical beam member 60 which directs optical radiation input from the optical source arrangement 402 towards the emitter arrangement 308, for example by directing the optical radiation input along waveguide 310. Alternatively, the optical source arrangement 402 may emit optical radiation at any angle relative to the plane of the optical beam member 60 containing the emitter arrangement 308, provided there is an in-coupler configured to couple the optical radiation towards the emitter arrangement 308 (optionally via the waveguide 310).

The in-coupler may be any optical element that enables efficient coupling of the optical radiation emitted by optical source arrangement 402 to waveguide 310. For example, the in-coupler 306 may be a diffraction grating. In another example, the in-coupler may be a coupling prism, configured to couple optical radiation from the optical source arrangement 402 into the waveguide 310. Alternatively, the in-coupler 306 may be a micro-mirror configured to redirect light from the optical source arrangement 402 to the waveguide 310. For example, in-coupler may be a micro-mirror disposed at 45 ° relative to the direction of the optical radiation from the optical source arrangement 402, and at 45 ° relative to the direction of the waveguide 310. The micro-mirror may be disposed at another angle, provided it redirects optical radiation from the optical source arrangement 402 to the waveguide 310 - for example, another angle may be appropriate when the optical source arrangement 402 is configured to emit optical radiation at an angle relative to the plane of the optical beam member 60 containing the emitter arrangement 308.

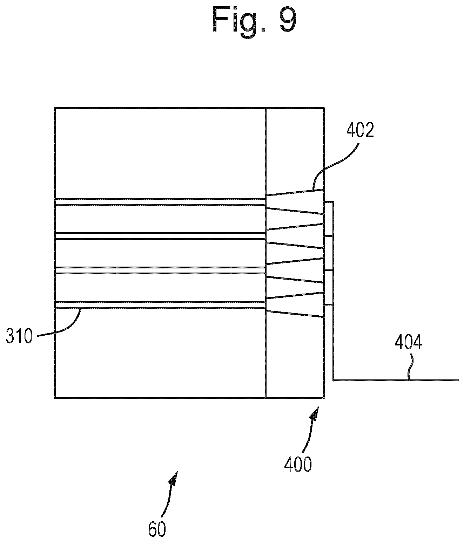

For brevity, the configuration in Figure 7 may be referred to as "in-plane" and the configuration shown in Figure 8 may be referred to as "out-of-plane". A plan view of the "in-plane" configuration of Figure 7 is shown in Figure 9.

The in-coupler 306 may be configured to receive optical radiation from the optical sources and direct the optical radiation 311 toward the emitter arrangement 308. The optical beam member 60 may be provided with a plurality of in-couplers configured to direct the optical radiation from the optical sources toward the emitter arrangement 308. Optical radiation from optical sources of the optical source arrangement 402 may be emitted toward respective in-couplers. When an optical beam member 60 comprises a plurality of waveguides, respective in-couplers may redirect optical radiation from one or more optical sources along respective waveguides.

While the in-coupler(s) 306 are described as being provided in the optical beam member 60, the in-couplers 306 may be provided in the optical source module 400. For example, the optical source arrangement 402 may emit optical radiation towards an in-coupler 306 of the optical source module 400, and the in-coupler 306 may direct the optical radiation to the optical beam member 60.

As mentioned previously, the optical sources may comprise edge-emitting lasers or surface-emitting lasers, both of which may be utilised in the in-plane configuration shown in Figure 7 or the out-of-plane configuration shown in Figure 8. The orientation of the edge-emitting lasers or surface emitting lasers within the optical source module 400 dictates the direction in which the optical radiation emission. In-couplers may be provided as appropriate to direct the optical radiation along the plane of the of the optical beam member 60 containing the emitter arrangement 308

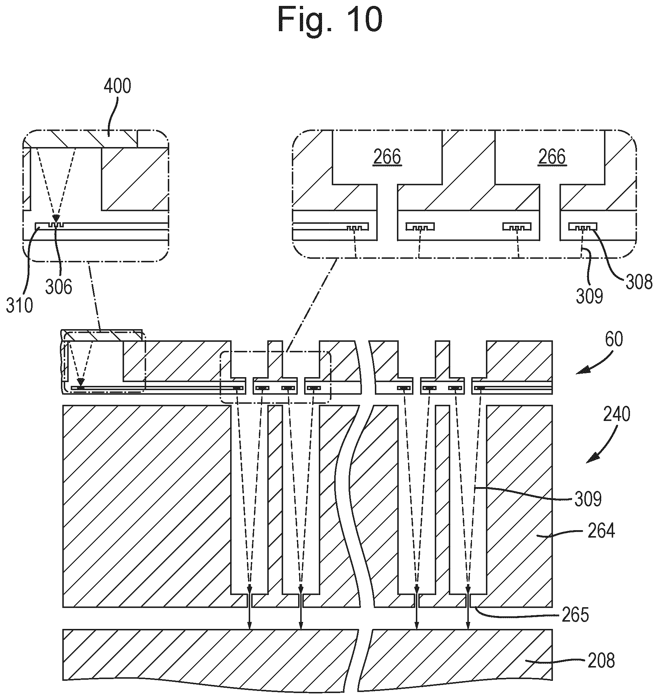

As mentioned previously with reference to Figure 2 to Figure 6, a charged particle-optical device may be configured to direct a plurality of charged particle beams along respective optical axes towards the sample location. The optical beam member 60 may be further configured for a multi-beam charged particle-optical device, and the optical beam member 60 may include a plurality of charged particle beam apertures 266 for passage of respective charged particle beams towards the sample location, where for each beam aperture, the optical beam member 60 includes at least one emitter arrangement 308 associated with a respective charged particle beam aperture 266. The emitter arrangement 308 may be configured to emit optical radiation towards the sample location. An optical beam member 60 for a multi-beam system may comprise any of the features of an optical beam member 60 described with reference to a single charged particle beam aperture 266. An optical beam member 60 may be provided with a plurality of emitter arrangements 308 associated with each charged-particle beam aperture 266. An example of an optical beam member 60 for a multi-beam system is shown schematically in Figure 10. The optical source arrangement 402 may comprise an array of optical sources and each optical source in an array of optical sources may be coupled to a respective emitter arrangement 308.

As shown in Figure 10, the optical beam member 60 may comprise a plurality of charged particle beam apertures 266, each configured passage of respective charged particle beams towards the sample location on sample 208. The optical beam member 60 comprises an optical source module 400 configured to input radiation toward the emitter arrangements 308. While Figure 10 shows an out-of-plane configuration, such as the configuration described with reference to Figure 8, an optical beam member 60 for a multi-beam system may be instead arranged in the in-plane configuration described with reference to Figure 7. The optical beam member 60 comprises in-coupler 306 configured to direct optical radiation toward the emitter arrangement 308. The optical beam member 60 comprises emitter arrangements 308 associated with each a respective beam aperture 266. The emitter arrangements 308 outcouple optical radiation 309 towards the sample location.

**In** any of the embodiments described herein, the emitter arrangement 308 may outcouple the optical radiation 309 so that it is substantially coincident with a charged particle beam spot on the sample. In a multi-beam arrangement, the emitter arrangements 308 may be disposed to outcouple optical radiation so it is substantially coincident with respective charged particle beam spots of the charged particle beams incident on the sample.

**In** some arrangements the optical beam member 60 may be considered as a component of an assembly for a charged particle-optical device 230, which may comprise a plurality of electron-optical elements. As described with reference to Figure 2, an electron-optical element may be configured to manipulate the charged particle beam or an element configured to detect particles/radiation emitted by the sample 208. The optical beam member 60 may integrated with an electron-optical element. For example, the optical beam member 60 may be integrated with the detector array 240. The optical beam member may be provided on the surface of the detector array 240 which faces the sample location. There may be further electron-optical elements disposed between the optical beam member 60 and the sample location. The arrangement of the optical beam member 60 in relation to the other electron optical elements is not particularly constrained, as long as the emitter arrangement(s) 308 of the optical beam member 60 are capable of emitting optical radiation towards the sample location. For example, the assembly may include the optical beam member 60 and at least one aperture element, or other optical components.

An aperture element (such as an electron-optical element comprising at least one aperture) may be disposed between the optical beam member 60 and the sample location. The aperture element may be the detector substrate 264, as shown in Figure 10. The aperture element may be provided with one or more second beam apertures for passage of the respective charged particle beam towards the sample location. The second beam apertures may be aligned with the respective charged particle beam apertures 266 in the optical beam member 60. The second beam apertures may enable passage of respective charged particle beams (such as respective charged particle beams 211, 212, 213 described with reference to Figure 2, Figure 3 or Figure 4) of the charged particle-optical device 230 towards the sample location.

The optical beam member 60 may be disposed upbeam the aperture element, the aperture element being upbeam of the sample 208, as shown in Figure 10 for example. The aperture element may consist of or comprise a detector, for example in the form of a detector array 240 (such as described above in reference to Figure 2 to Figure 6). The detector array 240 may face the sample location and may be configured to detect emitted charged particles from the sample location in response to the charged particle beam spot on the sample location.

The optical beam member 60 may be disposed downbeam of the aperture element. In some arrangements the optical beam member 60 may be integrated with the aperture element. For example, the optical beam member 60 may be co-planar with detector element 265. For example, in the arrangement shown in Figure 6 the emitter arrangements 308 (and optionally the waveguides) of the optical beam member 60 may be disposed in the same plane as the detector elements 265.

The charged particle-optical device 230 may be provided as part of a charged particle-optical apparatus (such as electron-optical apparatus 140) which may further comprise an actuatable stage configured to support a sample 208 (such as actuatable stage 209 described with reference to Figures 2 to 4). The actuatable stage 209 may move the sample 208 relative to the charged particle-optical device 230 so that the charged particle beam may be focused on the sample location during inspection with the charged particle-optical apparatus.

In some arrangements the charged particle-optical device may comprise an objective lens or an objective lens array 241, such as the objective lens array 241 described with reference to Figure 3 and Figure 4. The objective lens or an objective lens array 241 may be configured to focus the charged particle beam onto the sample location, and the optical beam member 60 may be disposed between the objective lens and the sample location. In other arrangements, the optical beam member 60 may be disposed up-beam of the objective lens.

The optical source module 400 may be electrically connected to a power supply via wiring 404, whereby the power supply delivers electrical power to one or more optical sources, enabling them to emit optical radiation. The power supply may be configured to provide sufficient power for the optical source module 400 to generate optical radiation with high enough intensity. For example, in some arrangements the power supply may provide between 1 W and 10 W of power to the optical source module 400.

In some arrangements the optical beam element 60 may be considered as a component of an assembly for a charged particle-optical device 230.

According to the invention, there is provided a method for directing optical radiation towards a sample location of a sample 208, the method comprising generating optical radiation by one or more optical sources of an optical source arrangement 402 of an optical source module 400, providing the optical radiation to an optical beam member 60 which comprises at least one emitter arrangement 308, the at least one emitter arrangement 308 configured to emit optical radiation the sample location, where one or more charged-particle beam apertures 266 are defined in the optical beam member 60 for passage of a respective charged particle beam towards the sample, and wherein the at least one emitter arrangement is associated with a respective charged particle beam aperture. This method may be performed when the optical beam member 60 is provided in the assessment apparatus 100, such that the optical source module 400 and the emitter arrangements 308 are both inside the vacuum chamber. This may be a particularly convenient way of illuminating the sample location with optical radiation during voltage contrast imaging, as the optical source module 400 generates and provides the optical radiation to the emitter arrangement within the confines of the vacuum chamber 110. For example, when the optical source module 400 is integrated with the optical beam member 60, the optical beam member 60 may be provided a single unit within the vacuum chamber 110. When the optical source module 400 is operatively detachable from the optical beam member 60, the optical source module 400 may be attached to the optical beam member 60 prior to installation in the vacuum chamber 110 of the assessment apparatus 100. In other words, the optical beam member 60 and the optical source module 400 may be close-coupled and installed in the vacuum chamber 110. An optical beam member 60 having any combination of features described herein may be used to perform this method. The method may be performed with a charged-particle apparatus comprising a charged particle-optical device 230 (such as an electron-optical device 230 described with reference to Figures 1-5), comprising the optical element 60 as one of its constituent elements, wherein the charged particle-optical device 230 is configured to direct the respective charged-particle beam towards the sample location.

Although specific reference may be made in this text to embodiments of the invention in the context of an electron microscope, embodiments of the invention may be used in other types of apparatus. Embodiments of the invention may form part of a mask inspection apparatus, a metrology apparatus, or any apparatus that measures or processes an object such as a wafer (or other substrate) or mask (or other patterning device).

Although specific reference may have been made above to the use of embodiments of the invention in the context of sample assessment, it will be appreciated that the invention, where the context allows, is not limited to sample assessment and may be used in other applications, for example electron beam lithography.

Exemplary embodiments of the present disclosure are set out in the following numbered clauses:
1. An optical beam member for a charged particle-optical device configured to direct a charged particle beam towards a sample location, the optical beam member comprising:
   a charged particle beam aperture for passage of the charged particle beam,
   an emitter arrangement associated with the charged particle beam aperture, the emitter arrangement configured to emit an optical radiation towards the sample location, and
   an optical source module comprising an optical source arrangement for providing an optical radiation input to the said emitter arrangement.
2. The optical beam member of clause 1, wherein the optical source module is close-coupled to the optical beam member.
3. The optical beam member of clause 1 or 2, wherein the optical source module is integrated with the optical beam member.
4. The optical beam member of clause 3, wherein the optical source module is integrated with the optical beam member via hybrid integration or heterogeneous integration.
5. The optical beam member of any preceding clause, wherein the optical source arrangement comprises an array of optical sources.
6. The optical beam member of clause 5, wherein the array of optical sources is directly coupled to the optical member.
7. The optical beam member of clause 1 or 2, wherein the optical source module is operatively detachable from the optical element.
8. The optical beam member of clause 7, wherein the optical source arrangement comprises an array of optical sources.
9. The optical beam member of any preceding clause, wherein the optical source module comprises an optical radiation manipulating arrangement coupled to the optical source arrangement, the optical radiation manipulating arrangement being configured to direct and/or focus optical radiation input, provided by the optical source arrangement, towards the emitter arrangement.
10. The optical beam member of any one of clauses 1 to 9, wherein the optical source arrangement comprises at least one solid-state laser.
11. The optical beam member of any one of clauses 1 to 10, wherein the optical source arrangement comprises at least one semiconductor laser.
12. The optical beam member of any one of clauses 1 to 11, wherein the optical source arrangement comprises at least one of an electrically-pumped laser or an optically pumped laser.
13. The optical beam member of any one of clauses 1 to 12, wherein the optical source arrangement comprises at least one of a vertical cavity surface emitting laser, a photonic-crystal cavity surface emitting laser, or an external cavity laser.
14. The optical beam member of any one of clauses 1 to 13, wherein the optical beam member comprises at least one waveguide for coupling the said optical radiation input to the emitter arrangement, and wherein the emitter arrangement is arranged to outcouple optical radiation from the at least one waveguide towards the sample location.
15. The optical beam member of any one of clauses 1 to 14, wherein the emitter arrangement comprises one or more grating couplers.
16. The optical beam member of any one of clauses 1 to 15, wherein the optical source module and optical beam member are arranged in-plane.
17. The optical beam member of clause 16, wherein the optical source arrangement of the optical source module is edge-coupled to the optical beam member.
18. The optical beam member of any one of clauses 1 to 17, wherein the optical source arrangement is arranged to emit optical radiation towards a plane of the optical beam member containing the emitter arrangement.
19. The optical beam member of any one of clauses **1-** 15, wherein the optical source arrangement is positioned up-beam of the plane of the optical beam member containing the emitter arrangement.
20. The optical beam member of clause 19, wherein the optical beam member further comprises an in-coupler configured to redirect the optical radiation towards the said emitter arrangement.
21. The optical beam member of any one of clauses 1 to 20, wherein the emitter arrangement is configured to emit the optical radiation towards the sample location such that an optical beam spot on the sample is substantially coincident with a charged particle beam spot on the sample.
22. The optical beam member of any one of clauses 1 to 21 being further configured for a charged particle-optical device configured to direct a plurality of charged particle beams along respective optical axes towards the sample location, wherein the optical beam member comprises a plurality of charged particle beam apertures for passage of respective charged particle beams towards the sample location, wherein for each beam aperture, the optical element comprises at least one emitter arrangement associated with a respective charged particle beam aperture and configured to emit optical radiation towards the sample location, wherein the optical source module comprising the optical source arrangement is configured to provide optical radiation input to the at least one emitter arrangement.
23. An optical beam member according to clause 22, when dependent on any one of clauses 5-21, wherein each optical source in an array of optical sources is coupled to a respective emitter arrangement.
24. The optical beam member of any of clauses 1 to 23, wherein the optical beam member is configured to be disposed inside a vacuum chamber of an assessment apparatus.
25. An assembly for a charged particle-optical device configured to direct a charged particle beam toward a sample location, the assembly comprising the optical beam member of any one of clauses 1 to 24.
26. The assembly of clause 25 comprising an aperture element between the optical beam member and the sample location, wherein a second beam aperture is defined in the aperture element for passage of the charged particle beam towards the sample location.
27. A charged particle-optical device configured to direct a charged particle beam towards a sample location, the charged particle-optical device comprising the assembly of clause 25 or 26.
28. The charged particle-optical device of clause 27, comprising an objective lens configured to focus the charged particle beam onto the sample location, wherein the optical beam member is between the objective lens and the sample location.
29. The charged particle-optical device of clause 27, comprising an objective lens configured to focus the charged particle beam onto the sample location, wherein the optical beam member is disposed up-beam of the objective lens.
30. A charged particle-optical apparatus comprising the charged particle-optical device of any one of clauses 27 to 29; and an actuatable stage configured to support a sample.
31. The charged particle-optical apparatus of clause 30 further comprising a vacuum chamber, wherein the optical beam member is disposed inside the vacuum chamber when the charged particle-optical apparatus is in use.
32. A method for directing optical radiation towards a sample location, the method comprising:
   generating optical radiation by an optical source arrangement of an optical source module,
   providing the optical radiation to an optical beam member comprising at least one emitter arrangement, the at least one emitter arrangement configured to emit optical radiation towards the sample location, the optical beam member being further configured to comprise the optical source module,
   wherein at least one charged-particle beam aperture is defined in the optical beam member for passage of a respective charged particle beam towards the sample, and wherein the at least one emitter arrangement is associated with a respective charged particle beam aperture.
33. The method of clause 32, wherein the optical source module is close-coupled to the optical beam member.
34. The method of clause 32 or clause 33, wherein optical radiation is emitted to the sample location so that an optical beam spot on the sample is substantially coincident with a charged particle beam spot on the sample.
35. The method of any one of clauses 32 to 34, further comprising directing, using a charged particle-optical device, a plurality of beams towards the sample, such that each of the charged particle beams passes through a respective charged-particle beam aperture.
36. The method of any one of clauses 32 to 35, wherein the optical beam member is disposed inside a vacuum chamber of an assessment apparatus.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

List of reference numerals:
60 optical beam member
100 assessment apparatus
110 vacuum chamber (main chamber)
120 load lock chamber
130 EFEM
130a first loading port
130b second loading port
140 electron-optical apparatus (electron beam apparatus, electron apparatus)
150 controller
201 source
202 source beam
207 sample holder
208 sample
209 actuatable stage
211, 212, 213 primary beams (sub-beams, beamlets)
230 electron-optical device (electron-optical column)
231 condenser lens array
240 detector array
241 objective lens array
242 beam shaper array
250 control lens array
252 beam limiting aperture array
260 scan deflector array
261 plate
264 detector substrate
265 detector elements
266 beam apertures
271 collimator array
273 intermediate focus plane
274 macro condenser lens
275 macro scan deflector
281-283 probe spots
299 electron-optical device array
306 in-coupler
308 emitter arrangement
309, 311 optical radiation
310 waveguide
400 optical source module
402 optical source arrangement
404 wiring

## Claims

1. An optical beam member for a charged particle-optical device configured to direct a charged particle beam towards a sample location, the optical beam member comprising:
a charged particle beam aperture for passage of the charged particle beam,
an emitter arrangement associated with the charged particle beam aperture, the emitter arrangement configured to emit an optical radiation towards the sample location, and
an optical source module comprising an optical source arrangement for providing an optical radiation input to the said emitter arrangement.

2. The optical beam member of claim 1, wherein the optical source module is close-coupled to the optical beam member.

3. The optical beam member of claim 1 or 2, wherein the optical source module is integrated with the optical beam member.

4. The optical beam member of claim 3, wherein the optical source module is integrated with the optical beam member via hybrid integration or heterogeneous integration.

5. The optical beam member of any preceding claim, wherein the optical source arrangement comprises an array of optical sources.

6. The optical beam member of claim 5, wherein the array of optical sources is directly coupled to the optical member.

7. The optical beam member of claim 1 or 2, wherein the optical source module is operatively detachable from the optical element.

8. The optical beam member of any one of claims 1 to 7, wherein the optical beam member comprises at least one waveguide for coupling the said optical radiation input to the emitter arrangement, and wherein the emitter arrangement is arranged to outcouple optical radiation from the at least one waveguide towards the sample location.

9. The optical beam member of any one of claims 1 to 8, wherein the optical source module and optical beam member are arranged in-plane.

10. The optical beam member of claim 9, wherein the optical source arrangement of the optical source module is edge-coupled to the optical beam member.

11. The optical beam member of any of claims 1-8, wherein the optical source arrangement is positioned up-beam of the plane of the optical beam member containing the emitter arrangement.

12. The optical beam member of claim 11, wherein the optical beam member further comprises an in-coupler configured to redirect the optical radiation towards the said emitter arrangement.

13. The optical beam member of any one of claims 1 to 12 being further configured for a charged particle-optical device configured to direct a plurality of charged particle beams along respective optical axes towards the sample location, wherein the optical beam member comprises a plurality of charged particle beam apertures for passage of respective charged particle beams towards the sample location, wherein for each beam aperture, the optical element comprises at least one emitter arrangement associated with a respective charged particle beam aperture and configured to emit optical radiation towards the sample location, wherein the optical source module comprising the optical source arrangement is configured to provide optical radiation input to the at least one emitter arrangement.

14. The optical beam member of any of claims 1 to 13, wherein the optical beam member is configured to be disposed inside a vacuum chamber of an assessment apparatus.

15. An assembly for a charged particle-optical device configured to direct a charged particle beam toward a sample location, the assembly comprising the optical beam member of any one of claims 1 to 14.
